# EUROPEAN PATENT SPECIFICATION

(11) **EP 4 152 614 B1**
(45) Date of publication and mention of the grant of the patent: **08.04.2026**
(21) Application number: 22190691.0
(22) Date of filing: 17.08.2022
(51) Int. Cl.: H03K 17/00, H03K 17/687, H03J 3/18, H03J 5/02, H03J 7/08

(54) **ELECTRONIC DEVICE**
ELEKTRONISCHE VORRICHTUNG
DISPOSITIF ÉLECTRONIQUE

(30) Priority: 16.09.2021 US 202163244725 P; 01.06.2022 US 202217829389
(43) Date of publication of application: 22.03.2023
(73) Proprietor: InnoLux Corporation, Chu-Nan, Miao-Li County 35053 (TW)
(72) Inventor: HASHIMOTO, Kazuyuki, 35053 Chu-Nan, Miao-Li County (TW)
(74) Representative: Becker, Eberhard

(56) References cited:
- EP-A1- 3 608 900
- EP-A1- 3 736 800
- US-A- 4 020 420
- US-A- 4 095 282

## Description

### BACKGROUND

### Technical Field

The disclosure relates a device, particularly, the disclosure relates to an electronic device.

### Description of Related Art

Antenna pixel circuit supplies a bias voltage to a varactor to control its permittivity with a storage capacitor (Cst). To keep the bias voltage within a specific range, the voltage needs to be restored (refresh) by data scan to compensate voltage drop by a leakage current of the varactor. However, there is a problem that higher leakage current requires higher refresh rates and/or larger storage capacitors to keep the bias voltage within a specific range, but which would be obstacles for commercialization. US 4020420 A relates to an electronic channel selector which includes variable resistors, switches connected to the variable resistors, respectively, and a voltage memory circuit.

### SUMMARY

The invention is set out in the appended set of claims. The following disclosure serves a better understanding of the present invention. The electronic device of the disclosure includes a tunable component and a first source follower circuit. The tunable component is electrically connected to a circuit node. The first source follower circuit is electrically connected to the circuit node. The first source follower circuit includes a first control terminal and a first terminal. The first control terminal is electrically connected to the first terminal.

Based on the above, according to the electronic device of the disclosure, the electronic device can effectively compensate the leakage current of the tunable component.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic diagram of an electronic device according to an embodiment of the disclosure.
FIG. 2 is a timing diagram of related voltages and signals according to the embodiment of FIG. 1 of the disclosure.
FIG. 3 is a schematic diagram of an electronic device according to an embodiment of the disclosure.
FIG. 4 is a timing diagram of related voltages and signals according to the embodiment of FIG. 3 of the disclosure.
FIG. 5 is a schematic diagram of an electronic device according to an embodiment of the disclosure.
FIG. 6 is a timing diagram of related voltages and signals according to the embodiment of FIG. 5 of the disclosure.
FIG. 7 is a schematic diagram of an electronic device according to an embodiment of the disclosure.
FIG. 8 is a timing diagram of related voltages and signals according to the embodiment of FIG. 7 of the disclosure.
FIG. 9 is a schematic diagram of an electronic device according to an embodiment of the disclosure.
FIG. 10 is a schematic diagram of an electronic device according to an embodiment of the disclosure.
FIG. 11 is a schematic diagram of an electronic device according to an embodiment of the disclosure.
FIG. 12 is a schematic diagram of an electronic device according to an embodiment of the disclosure.
FIG. 13 is a timing diagram of related voltages and signals according to the embodiment of FIG. 12 of the disclosure.

### DESCRIPTION OF THE EMBODIMENTS

Reference will now be made in detail to the exemplary embodiments of the disclosure, examples of which are illustrated in the accompanying drawings. Whenever possible, the same reference numbers are used in the drawings and the description to refer to the same or like components.

Certain terms are used throughout the specification and appended claims of the disclosure to refer to specific components. Those skilled in the art should understand that electronic device manufacturers may refer to the same components by different names. This article does not intend to distinguish those components with the same function but different names. In the following description and rights request, the words such as "comprise" and "include" are open-ended terms, and should be explained as "including but not limited to...".

The term "coupling (or electrically connection)" used throughout the whole specification of the present application (including the appended claims) may refer to any direct or indirect connection means. For example, if the text describes that a first device is coupled (or connected) to a second device, it should be interpreted that the first device may be directly connected to the second device, or the first device may be indirectly connected through other devices or certain connection means to be connected to the second device. The terms "first", "second", and similar terms mentioned throughout the whole specification of the present application (including the appended claims) are merely used to name discrete elements or to differentiate among different embodiments or ranges. Therefore, the terms should not be regarded as limiting an upper limit or a lower limit of the quantity of the elements and should not be used to limit the arrangement sequence of elements. In addition, wherever possible, elements/components/steps using the same reference numerals in the drawings and the embodiments represent the same or similar parts. Reference may be mutually made to related descriptions of elements/components/steps using the same reference numerals or using the same terms in different embodiments.

The electronic device of the disclosure may include, for example, an antenna pixel circuit, and the tunable component may correspond to an antenna unit of one pixel of the antenna pixel. The tunable component of the disclosure may be a voltage-controlled device, and the voltage-controlled device may include, for example, a varactor, a resistor, an inductor or a capacitor. In the embodiment of the disclosure, the constant voltage source circuit of the disclosure may provide a voltage that can be efficiently restored (refreshed) through data scanning to compensate for the voltage drop caused by the leakage current of the varactor of the tunable component.

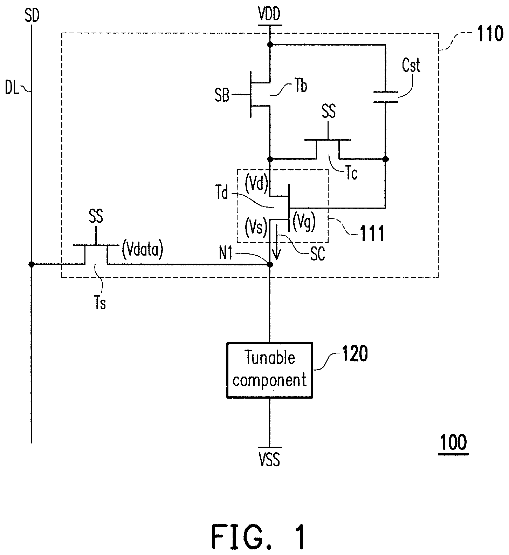

FIG. 1 is a schematic diagram of an electronic device according to an embodiment of the disclosure. Referring to FIG. 1, the electronic device 100 includes a constant voltage source circuit 110, a tunable component 120 and a data line DL. The constant voltage source circuit 110 is electrically connected to the tunable component 120 and the data line DL. In the embodiment of the disclosure, the constant voltage source circuit 110 includes a source follower circuit 111, a compensation transistor Tc, a bias transistor Tb, a scan transistor Ts and a storage capacitor Cst, and the source follower circuit 111 includes a drive transistor Td. In the embodiment of the disclosure, the drive transistor Td, the compensation transistor Tc, the bias transistor Tb and the scan transistor Ts are N-type transistors, such as a N-type metal oxide semiconductor (NMOS). In the embodiment of the disclosure, a first terminal of the drive transistor Td is electrically connected to a first terminal of the compensation transistor Tc. A control terminal of the drive transistor Td is electrically connected to a second terminal of the compensation transistor Tc. A second terminal of the drive transistor Td is electrically connected to a circuit node N1. A first terminal of the bias transistor Tb is electrically connected to an operation voltage VDD. A second terminal of the bias transistor Tb is electrically connected to the first terminal of the drive transistor Td. A first terminal of the storage capacitor Cst is electrically connected to the operation voltage VDD, and a second terminal of the storage capacitor Cst is electrically connected to the second terminal of the compensation transistor Tc and the control terminal of the drive transistor Td. In one embodiment of the disclosure, the second terminal of the storage capacitor Cst may electrically connected to a reference voltage. A first terminal of the scan transistor Ts is electrically connected to the data line DL. A second terminal of the scan transistor Ts is electrically connected to the circuit node N1. The tunable component 120 is electrically connected between the circuit node N1 and the voltage VSS. In the embodiment of the disclosure, the voltage VDD may greater than the voltage VSS.

In the embodiment of the disclosure, the drive transistor Td may be operated as a source follower amplifier. The compensation transistor Tc is configured to let the drive transistor Td to form a diode unit when the compensation transistor Tc is turned on. The bias transistor Tb is configured to provide the driving voltage (e.g., the operation voltage VDD) to the drive transistor Td when the bias transistor Tb is turned on. The storage capacitor Cst is configured to hold the voltage for the control terminal of the drive transistor Td. In the embodiment of the disclosure, a control terminal of the compensation transistor Tc and a control terminal of the scan transistor Ts may receive a scan signal SS. A control terminal of the bias transistor Tb may receive a bias signal SB. The data line DL may transmit a data signal SD. In the embodiment of the disclosure, the first terminal of the drive transistor Td may be, for example, a drain electrode of the transistor. The second terminal of the drive transistor Td may be, for example, a source electrode of the transistor. The control terminal of each transistor in the embodiment may be, for example, a gate electrode of the transistor.

In the embodiment of the disclosure, the constant voltage source circuit 110 may effectively and automatically compensate the leakage current of the tunable component 120, and at the same time, the threshold voltage Vth of the driving transistor Td may also be compensated, so that the bias voltage (Vbias) of the tunable component 120 may be effectively maintained.

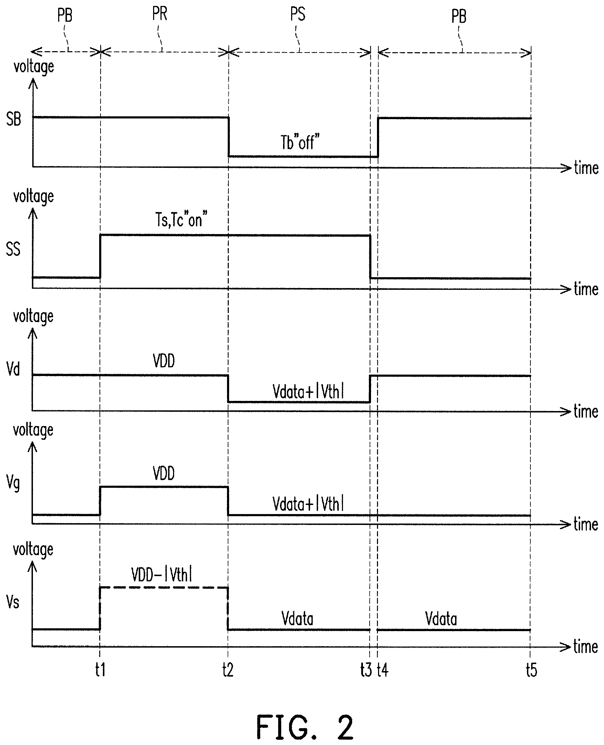

FIG. 2 is a timing diagram of related voltages and signals according to the embodiment of FIG. 1 of the disclosure. Referring to FIG. 1 and FIG. 2, during a reset period PR from time t1 to time t2, the bias transistor Tb, the scan transistor Ts and the compensation transistor Tc are turned on by the bias signal SB and the scan signal SS with a high voltage level, so that the first terminal and the control terminal of the drive transistor Td receive the operation voltage VDD. The voltage Vd of the first terminal and the voltage Vg of the control terminal of the drive transistor Td may be the operation voltage VDD. Thus, the drive transistor Td is operated in a conducting state like a diode unit, so that the voltage Vs of the second terminal of the drive transistor Td may equal to the operation voltage VDD minus the threshold voltage |Vth| of the drive transistor Td.

During a scan period PS from time t2 to time t3, the bias transistor Tb is turned off by the bias signal SB with a low voltage level, and the scan transistor Ts and the compensation transistor Tc are turned on by the scan signal SS with the high voltage level, so that the drive transistor Td is operated as a diode unit. The data line DL may provide the data signal SD to the scan transistor Ts which is turned on, so the voltage Vs of the second terminal of the drive transistor Td may be a data voltage Vdata. At the same time, due to the operation voltage VDD is higher than the data voltage Vdata (VDD > Vdata > VSS), a current may be transmitted from the control terminal of the drive transistor Td to the second terminal of the drive transistor Td through the compensation transistor Tc. Thus, the drive transistor Td is operated in a conducting state like a diode unit, so that the voltage Vg of control terminal of the drive transistor Td may be a voltage of Vdata+ | Vth | , where Vth is a threshold voltage of the drive transistor Td. Moreover, the voltage Vd of the first terminal of the drive transistor Td may also be the voltage of Vdata+ | Vth | .

During a bias period PB from time t4 to time t5, the bias transistor Tb is turned on by the bias signal SB with the high voltage level, and the scan transistor Ts and the compensation transistor Tc are turned off by the scan signal SS with a low voltage level. Since the bias transistor Tb is turned on, the voltage Vd of the first terminal of the drive transistor Td may be the operation voltage VDD. The voltage Vg of control terminal of the drive transistor Td may be maintained the voltage of Vdata+ | Vth | . The voltage Vs of the second terminal of the drive transistor Td may be the data voltage Vdata. At the same time, the tunable component 120 is operated in a working state, and the second terminal of the drive transistor Td provides a source current SC to the tunable component 120 according to the operation voltage VDD. It should be noted that, when the tunable component 120 occurs a leakage current, a bias voltage (Vbias) of the tunable component 120 may drop (Vbias-dV), and the voltage Vs of the second terminal of the drive transistor Td may also drop, where the symbol "dV" means a delta voltage. Therefore, the drive transistor Td may provide more current to the tunable component 120 to compensate the leakage current of the tunable component 120, and at the same time, the threshold voltage Vth of the driving transistor Td can be compensated, so that the bias voltage (Vbias) of the tunable component 120 may be effectively maintained during the bias period PB.

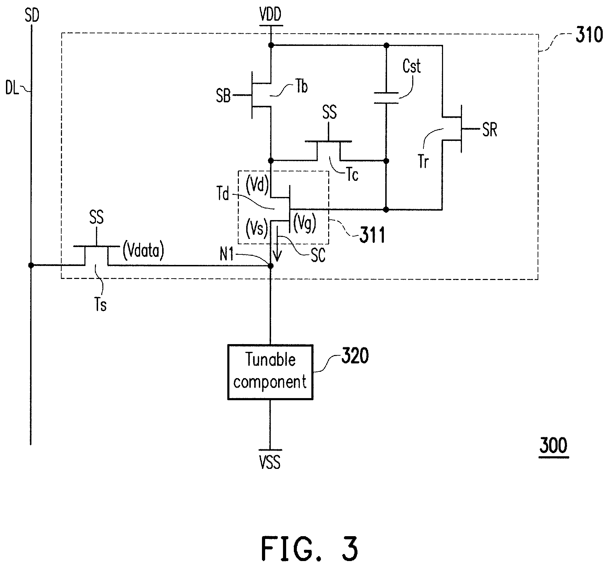

FIG. 3 is a schematic diagram of an electronic device according to an embodiment of the disclosure. Referring to FIG. 3, the electronic device 300 includes a constant voltage source circuit 310, a tunable component 320 and a data line DL. The constant voltage source circuit 310 is electrically connected to the tunable component 320 and the data line DL. In the embodiment of the disclosure, the constant voltage source circuit 310 includes a source follower circuit 311, a compensation transistor Tc, a bias transistor Tb, a scan transistor Ts, a reset transistor Tr and a storage capacitor Cst, and the source follower circuit 311 includes a drive transistor Td. In the embodiment of the disclosure, the drive transistor Td, the compensation transistor Tc, the bias transistor Tb, the scan transistor Ts and the reset transistor Tr are N-type transistors, such as a NMOS. In the embodiment of the disclosure, a first terminal of the drive transistor Td is electrically connected to a first terminal of the compensation transistor Tc. A control terminal of the drive transistor Td is electrically connected to a second terminal of the compensation transistor Tc. A second terminal of the drive transistor Td is electrically connected to a circuit node N1. A first terminal of the bias transistor Tb is electrically connected to an operation voltage VDD. A second terminal of the bias transistor Tb is electrically connected to the first terminal of the drive transistor Td. A first terminal of the storage capacitor Cst is electrically connected to the operation voltage VDD, and a second terminal of the storage capacitor Cst is electrically connected to the second terminal of the compensation transistor Tc and the control terminal of the drive transistor Td. In one embodiment of the disclosure, the second terminal of the storage capacitor Cst may electrically connected to a reference voltage. A first terminal of the scan transistor Ts is electrically connected to the data line DL. A second terminal of the scan transistor Ts is electrically connected to the circuit node N1. A first terminal of the reset transistor Tr is electrically connected to the operation voltage VDD. A second terminal of the reset transistor Tr is electrically connected to the control terminal of the drive transistor Td. The tunable component 120 is electrically connected between the circuit node N1 and the voltage VSS.

In the embodiment of the disclosure, the drive transistor Td may be operated as a source follower amplifier. The compensation transistor Tc is configured to let the drive transistor Td to form a diode unit when the compensation transistor Tc is turned on. The bias transistor Tb is configured to provide a first operation voltage (e.g., the operation voltage VDD) to the drive transistor Td when the bias transistor Tb is turned on. The storage capacitor Cst is configured to hold the voltage for the control terminal of the drive transistor Td. The reset transistor Tr is configured to reset the voltage of the control terminal of the drive transistor Td. In the embodiment of the disclosure, a control terminal of the compensation transistor Tc and a control terminal of the scan transistor Ts may receive a scan signal SS. A control terminal of the bias transistor Tb may receive a bias signal SB. A control terminal of the reset transistor Tr may receive a reset signal SR. The data line DL may transmit a data signal SD.

In the embodiment of the disclosure, the constant voltage source circuit 310 may effectively and automatically compensate the leakage current of the tunable component 320, and at the same time, the threshold voltage Vth of the driving transistor Td may also be compensated, so that the bias voltage (Vbias) of the tunable component 320 may be effectively maintained.

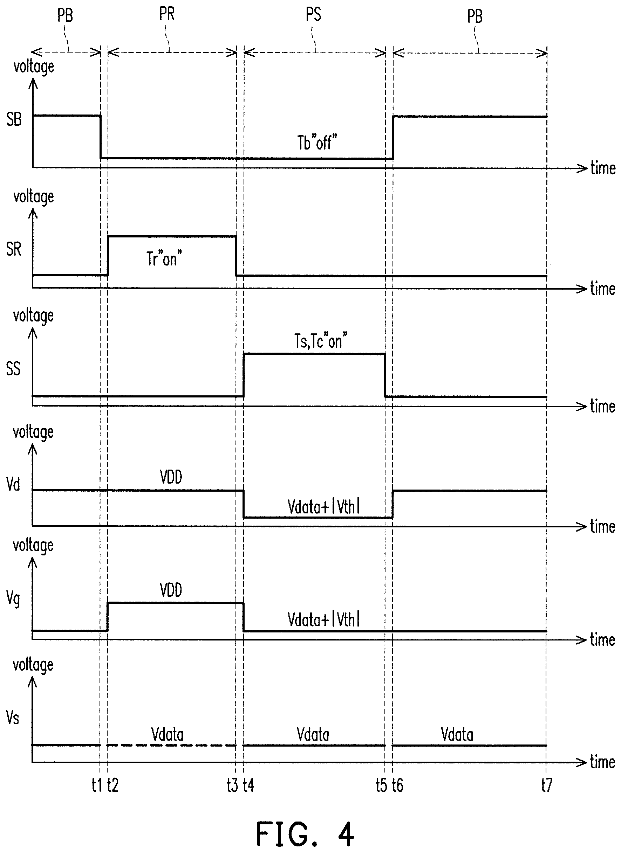

FIG. 4 is a timing diagram of related voltages and signals according to the embodiment of FIG. 3 of the disclosure. Referring to FIG. 3 and FIG. 4, during a reset period PR from time t2 to time t3, the reset transistor Tr is turned on by the reset signal SR with a high voltage level, and the bias transistor Tb, the scan transistor Ts and the compensation transistor Tc are turned off by the bias signal SB and the scan signal SS with a low voltage level, so that the control terminal of the drive transistor Td receive the operation voltage VDD, and the voltage Vd of the first terminal of the drive transistor Td may be maintained at the operation voltage VDD from the previous bias period PB before the time t1. Moreover, the voltage Vs of the second terminal of the drive transistor Td may be maintained at a voltage from the previous bias period PB before the time t1 such as a data voltage Vdata.

During a scan period PS from time t4 to time t5, the reset transistor Tr and the bias transistor Tb are turned off by the bias signal SB and the reset signal SR with the low voltage level, and the scan transistor Ts and the compensation transistor Tc are turned on by the scan signal SS with the high voltage level, so that the drive transistor Td is operated as a diode unit. The data line DL may provide the data signal SD to the scan transistor Ts which is turned on, so the voltage Vs of the second terminal of the drive transistor Td may be the data voltage Vdata. At the same time, due to the operation voltage VDD is higher than the data voltage Vdata (VDD > Vdata > VSS), a current may be transmitted from the control terminal of the drive transistor Td to the second terminal of the drive transistor Td through the compensation transistor Tc. Thus, the drive transistor Td is operated in a conducting state like a diode unit, so that the voltage Vg of control terminal of the drive transistor Td may be a voltage of Vdata+ | Vth | , where Vth is a threshold voltage of the drive transistor Td. Moreover, the voltage Vd of the first terminal of the drive transistor Td may also be the voltage of Vdata+ | Vth | .

During a bias period PB from time t6 to time t7, the bias transistor Tb is turned on by the bias signal SB with the high voltage level, and the reset transistor Tr, the scan transistor Ts and the compensation transistor Tc are turned off by the reset signal SR and the scan signal SS with a low voltage level. Since the bias transistor Tb is turned on, the voltage Vd of the first terminal of the drive transistor Td may be the operation voltage VDD. The voltage Vg of control terminal of the drive transistor Td may be maintained the voltage of Vdata+ | Vth | . The voltage Vs of the second terminal of the drive transistor Td may be the data voltage Vdata. At the same time, the tunable component 320 is operated in a working state, and the second terminal of the drive transistor Td provides a source current SC to the tunable component 320 according to the operation voltage VDD. It should be noted that, when the tunable component 320 occurs a leakage current, a bias voltage (Vbias) of the tunable component 120 may drop (Vbias-dV), and the voltage Vs of the second terminal of the drive transistor Td may also drop. Therefore, the drive transistor Td may provide more current to the tunable component 320 to compensate the leakage current of the tunable component 320, and at the same time, the threshold voltage Vth of the driving transistor Td can be compensated, so that the bias voltage (Vbias) of the tunable component 320 may be effectively maintained during the bias period PB.

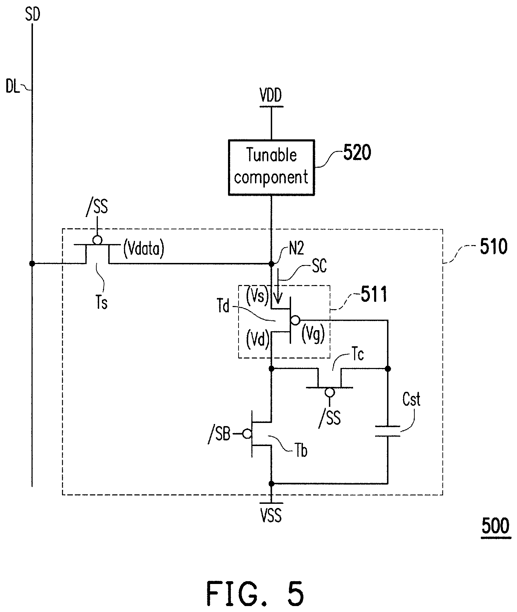

FIG. 5 is a schematic diagram of an electronic device according to an embodiment of the disclosure. Referring to FIG. 5, the electronic device 500 includes a constant voltage source circuit 510, a tunable component 520 and a data line DL. The constant voltage source circuit 510 is electrically connected to the tunable component 520 and the data line DL. In the embodiment of the disclosure, the constant voltage source circuit 510 includes a source follower circuit 511, a compensation transistor Tc, a bias transistor Tb, a scan transistor Ts and a storage capacitor Cst, and the source follower circuit 511 includes a drive transistor Td. In the embodiment of the disclosure, the drive transistor Td, the compensation transistor Tc, the bias transistor Tb and the scan transistor Ts are P-type transistors, such as a P-type metal oxide semiconductor (PMOS). In the embodiment of the disclosure, a first terminal of the drive transistor Td is electrically connected to a circuit node N2. A second terminal of the drive transistor Td is electrically connected to a first terminal of the bias transistor Tb and a first terminal of the compensation transistor Tc. A control terminal of the drive transistor Td is electrically connected to a second terminal of the compensation transistor Tc. A first terminal of the bias transistor Tb is electrically connected to the second terminal of the drive transistor Td. A second terminal of the bias transistor Tb is electrically connected to a voltage VSS. A first terminal of the storage capacitor Cst is electrically connected to the control terminal of the drive transistor Td and a second terminal of the compensation transistor Tc, and a second terminal of the storage capacitor Cst is electrically connected to the voltage VSS. In one embodiment of the disclosure, the second terminal of the storage capacitor Cst may electrically connected to a reference voltage. A first terminal of the scan transistor Ts is electrically connected to the data line DL. A second terminal of the scan transistor Ts is electrically connected to the circuit node N2. The tunable component 120 is electrically connected between the circuit node N2 and the operation voltage VDD.

In the embodiment of the disclosure, the drive transistor Td may be operated as a source follower amplifier. The compensation transistor Tc is configured to let the drive transistor Td to form a diode unit when the compensation transistor Tc is turned on. The bias transistor Tb is configured to provide a second operation voltage (e.g., voltage VSS) to the drive transistor Td when the bias transistor Tb is turned on. In the embodiment of the disclosure, the storage capacitor Cst is configured to hold the voltage for the control terminal of the drive transistor Td. In the embodiment of the disclosure, a control terminal of the compensation transistor Tc and a control terminal of the scan transistor Ts may receive a scan signal /SS. A control terminal of the bias transistor Tb may receive a bias signal /SB. The data line DL may transmit a data signal SD. In the embodiment of the disclosure, the first terminal of the drive transistor Td may be, for example, a source electrode of the transistor. The second terminal of the drive transistor Td may be, for example, a drain electrode of the transistor. The control terminal of each transistor in the embodiment may be, for example, a gate electrode of the transistor.

In the embodiment of the disclosure, the constant voltage source circuit 510 may effectively and automatically compensate the leakage current of the tunable component 520, and at the same time, the threshold voltage Vth of the driving transistor Td may also be compensated, so that the bias voltage (Vbias) of the tunable component 520 may be effectively maintained.

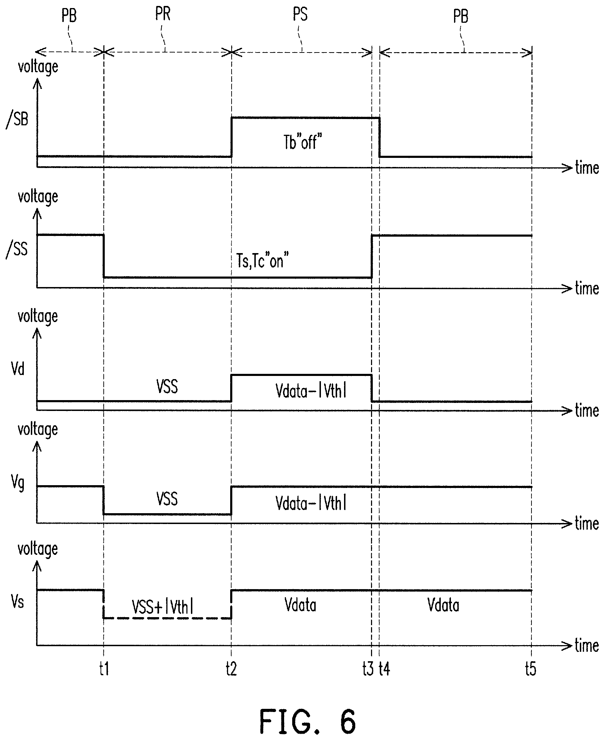

FIG. 6 is a timing diagram of related voltages and signals according to the embodiment of FIG. 5 of the disclosure. Referring to FIG. 5 and FIG. 6, during a reset period PR from time t1 to time t2, the bias transistor Tb, the scan transistor Ts and the compensation transistor Tc are turned on by the bias signal /SB and the scan signal /SS with a low voltage level, so that the second terminal and the control terminal of the drive transistor Td receive the voltage VSS. The voltage Vd of the second terminal and the voltage Vg of the control terminal of the drive transistor Td may be the voltage VSS. Thus, the drive transistor Td is operated in a conducting state like a diode unit, so that the voltage Vs of the first terminal of the drive transistor Td may equal to the voltage VSS plus an absolute value of a threshold voltage (|Vth|) of the drive transistor Td.

During a scan period PS from time t2 to time t3, the bias transistor Tb is turned off by the bias signal /SB with a high voltage level, and the scan transistor Ts and the compensation transistor Tc are turned on by the scan signal /SS with the low voltage level, so that the drive transistor Td is operated as a diode unit. The data line DL may provide the data signal SD to the scan transistor Ts which is turned on, so the voltage Vs of the first terminal of the drive transistor Td may be a data voltage Vdata. At the same time, due to the data voltage Vdata is higher than (VDD > Vdata > VSS) the voltage VSS, a current may be transmitted from the first terminal of the drive transistor Td to the control terminal of the drive transistor Td through the compensation transistor Tc. Thus, the drive transistor Td is operated in a conducting state like a diode unit, so that the voltage Vg of control terminal of the drive transistor Td may be a voltage of Vdata- | Vth | , where Vth is a threshold voltage of the drive transistor Td. Moreover, the voltage Vd of the second terminal of the drive transistor Td may also be the voltage of Vdata- | Vth | .

During a bias period PB from time t4 to time t5, the bias transistor Tb is turned on by the bias signal /SB with the low voltage level, and the scan transistor Ts and the compensation transistor Tc are turned off by the scan signal /SS with a high voltage level. Since the bias transistor Tb is turned on, the voltage Vd of the second terminal of the drive transistor Td may be the voltage VSS. The voltage Vg of control terminal of the drive transistor Td may be maintained the voltage of Vdata- | Vth | . The voltage Vs of the second terminal of the drive transistor Td may be the data voltage Vdata. At the same time, the tunable component 520 is operated in a working state, and the first terminal of the drive transistor Td generates a sink current SC from the tunable component 520. It should be noted that, when the tunable component 520 occurs a leakage current, a bias voltage (Vbias) of the tunable component 520 may increase (Vbias+dV), and the voltage Vs of the second terminal of the drive transistor Td may also increase. Therefore, the drive transistor Td may generate more current to the voltage VSS through the bias transistor Tb, so that the leakage current of the tunable component 520 may be compensate automatically. At the same time, the threshold voltage Vth of the driving transistor Td can be compensated, so that the bias voltage (Vbias) of the tunable component 520 may be effectively maintained during the bias period PB.

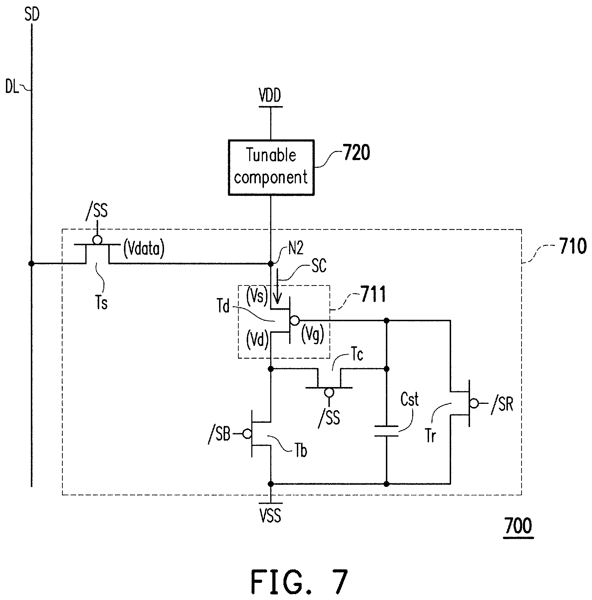

FIG. 7 is a schematic diagram of an electronic device according to an embodiment of the disclosure. FIG. 7 is a schematic diagram of an electronic device according to an embodiment of the disclosure. Referring to FIG. 7, the electronic device 700 includes a constant voltage source circuit 710, a tunable component 720 and a data line DL. The constant voltage source circuit 710 is electrically connected to the tunable component 720 and the data line DL. In the embodiment of the disclosure, the constant voltage source circuit 710 includes a source follower circuit 711, a compensation transistor Tc, a bias transistor Tb, a scan transistor Ts, a reset transistor Tr and a storage capacitor Cst, and the source follower circuit 711 includes a drive transistor Td. In the embodiment of the disclosure, the drive transistor Td, the compensation transistor Tc, the bias transistor Tb, the scan transistor Ts and the reset transistor Tr are P-type transistors, such as a PMOS. In the embodiment of the disclosure, a first terminal of the drive transistor Td is electrically connected to a circuit node N2. A second terminal of the drive transistor Td is electrically connected to a first terminal of the bias transistor Tb and the first terminal of compensation transistor Tr. A control terminal of the drive transistor Td is electrically connected to a second terminal of the compensation transistor Tc. A first terminal of the bias transistor Tb is electrically connected to the second terminal of the drive transistor Td. A second terminal of the bias transistor Tb is electrically connected to a voltage VSS. A first terminal of the storage capacitor Cst is electrically connected to the control terminal of the drive transistor Td and a second terminal of the compensation transistor Tc, and a second terminal of the storage capacitor Cst is electrically connected to the voltage VSS. In one embodiment of the disclosure, the second terminal of the storage capacitor Cst may electrically connected to a reference voltage. A first terminal of the scan transistor Ts is electrically connected to the data line DL. A second terminal of the scan transistor Ts is electrically connected to the circuit node N2. A first terminal of the reset transistor Tr is electrically connected to control terminal of the drive transistor Td. A second terminal of the reset transistor Tr is electrically connected to the voltage VSS and the second terminal of the bias transistor Tb. The tunable component 720 is electrically connected between the circuit node N2 and the operation voltage VDD.

In the embodiment of the disclosure, the drive transistor Td may be operated as a source follower amplifier. The compensation transistor Tc is configured to let the drive transistor Td to form a diode unit when the compensation transistor Tc is turned on. The bias transistor Tb is configured to provide a second operation voltage (e.g., the voltage VSS) to the drive transistor Td when the bias transistor Tb is turned on. The storage capacitor Cst is configured to hold the voltage for the control terminal of the drive transistor Td. The reset transistor Tr is configured to reset the voltage of the control terminal of the driver transistor Td. In the embodiment of the disclosure, a control terminal of the compensation transistor Tc and a control terminal of the scan transistor Ts may receive a scan signal /SS. A control terminal of the bias transistor Tb may receive a bias signal /SB. A control terminal of the reset transistor Tr may receive a reset signal /SR. The data line DL may transmit a data signal SD.

In the embodiment of the disclosure, the constant voltage source circuit 710 may effectively and automatically compensate the leakage current of the tunable component 720, and at the same time, the threshold voltage Vth of the driving transistor Td may also be compensated, so that the bias voltage (Vbias) of the tunable component 720 may be effectively maintained.

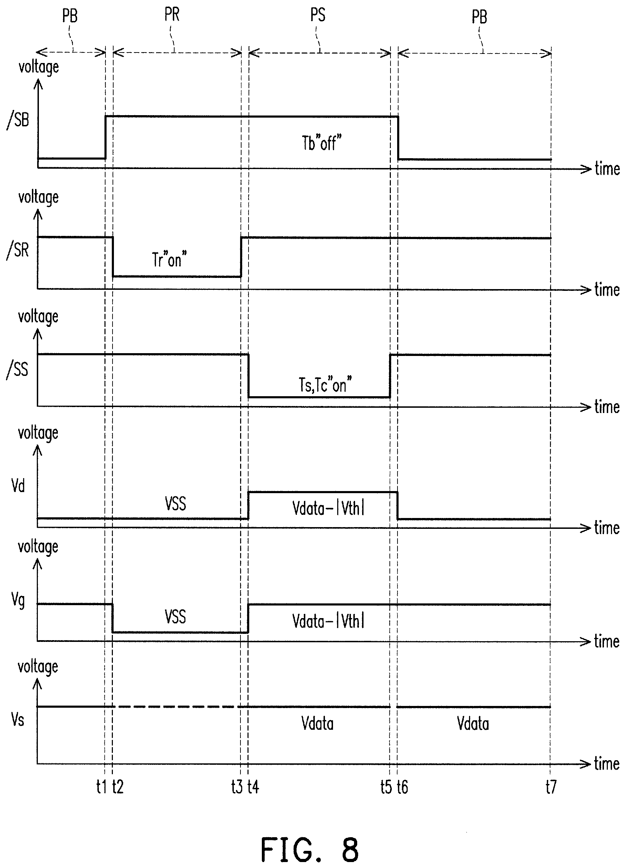

FIG. 8 is a timing diagram of related voltages and signals according to the embodiment of FIG. 7 of the disclosure. Referring to FIG. 7 and FIG. 8, during a reset period PR from time t2 to time t3, the reset transistor Tr is turned on by the reset signal /SR with a low voltage level, and the bias transistor Tb, the scan transistor Ts and the compensation transistor Tc are turned off by the bias signal /SB and the scan signal /SS with a high voltage level, so that the control terminal of the drive transistor Td receive the voltage VSS., and the voltage Vd of the first terminal of the drive transistor Td may be maintained at the voltage VSS from the previous bias period PB before the time t1. Moreover, the voltage Vs of the first terminal of the drive transistor Td may be maintained at a voltage from the previous bias period PB before the time t1 such as a data voltage Vdata.

During a scan period PS from time t4 to time t5, the reset transistor Tr and the bias transistor Tb are turned off by the bias signal /SB and the reset signal /SR with the high voltage level, and the scan transistor Ts and the compensation transistor Tc are turned on by the scan signal /SS with the low voltage level, so that the drive transistor Td is operated as a diode unit. The data line DL may provide the data signal SD to the scan transistor Ts which is turned on, so the voltage Vs of the second terminal of the drive transistor Td may be a data voltage Vdata. At the same time, due to the data voltage Vdata is higher than the ground voltage VSS (VDD > Vdata > VSS), a current may be transmitted from the first terminal of the drive transistor Td to the control terminal of the drive transistor Td through the compensation transistor Tc. Thus, the drive transistor Td is operated in a conducting state like a diode unit, so that the voltage Vg of control terminal of the drive transistor Td may be a voltage of Vdata- | Vth | , where Vth is a threshold voltage of the drive transistor Td. Moreover, the voltage Vd of the first terminal of the drive transistor Td may also be the voltage of Vdata- | Vth | .

During a bias period PB from time t6 to time t7, the bias transistor Tb is turned on by the bias signal /SB with the low voltage level, and the reset transistor Tr, the scan transistor Ts and the compensation transistor Tc are turned off by the reset signal SR and the scan signal SS with the high voltage level. Since the bias transistor Tb is turned on, the voltage Vd of the first terminal of the drive transistor Td may be the voltage VSS. The voltage Vg of control terminal of the drive transistor Td may be maintained the voltage of Vdata- | Vth | . The voltage Vs of the first terminal of the drive transistor Td may be the data voltage Vdata. At the same time, the tunable component 720 is operated in a working state, and the first terminal of the drive transistor Td generates a sink current SC from the tunable component 720. It should be noted that, when the tunable component 720 occurs a leakage current, a bias voltage (Vbias) of the tunable component 720 may increase (Vbias+dV), and the voltage Vs of the first terminal of the drive transistor Td may also increase. Therefore, the drive transistor Td may generate more current to the voltage VSS through the bias transistor Tb, so that the leakage current of the tunable component 720 may be compensate automatically. At the same time, the threshold voltage Vth of the driving transistor Td can be compensated, so that the bias voltage (Vbias) of the tunable component 720 may be effectively maintained during the bias period PB.

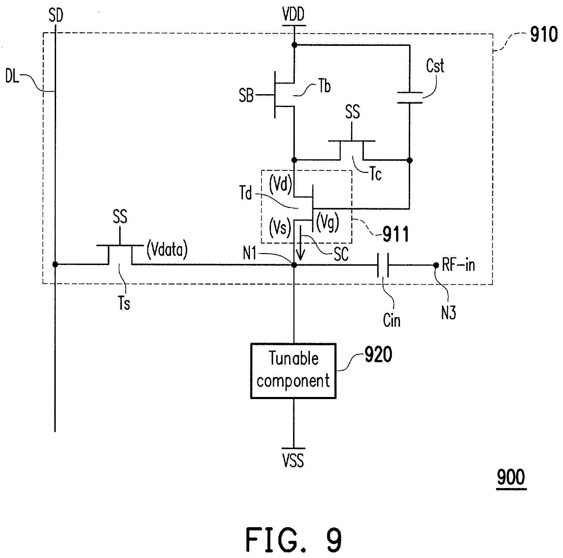

FIG. 9 is a schematic diagram of an electronic device according to an embodiment of the disclosure. Referring to FIG. 9, the electronic device 900 includes a constant voltage source circuit 910, a tunable component 920 and a data line DL. The constant voltage source circuit 910 is electrically connected to the tunable component 920 and the data line DL. In the embodiment of the disclosure, the constant voltage source circuit 910 includes a source follower circuit 911, a compensation transistor Tc, a bias transistor Tb, a scan transistor Ts, a storage capacitor Cst and an input capacitor Cin, and the source follower circuit 911 includes a drive transistor Td. In the embodiment of the disclosure, the drive transistor Td, the compensation transistor Tc, the bias transistor Tb and the scan transistor Ts are N-type transistors, such as a NMOS. In the embodiment of the disclosure, a first terminal of the drive transistor Td is electrically connected to a first terminal of the compensation transistor Tc. A control terminal of the drive transistor Td is electrically connected to a second terminal of the compensation transistor Tc. A second terminal of the drive transistor Td is electrically connected to a circuit node N1. A first terminal of the bias transistor Tb is electrically connected to an operation voltage VDD. A second terminal of the bias transistor Tb is electrically connected to the first terminal of the drive transistor Td. A first terminal of the storage capacitor Cst is electrically connected to the operation voltage VDD, and a second terminal of the storage capacitor Cst is electrically connected to the second terminal of the compensation transistor Tc and the control terminal of the drive transistor Td. In one embodiment of the disclosure, the second terminal of the storage capacitor Cst may electrically connected to a reference voltage. A first terminal of the scan transistor Ts is electrically connected to the data line DL. A second terminal of the scan transistor Ts is electrically connected to the circuit node N1. The tunable component 920 is electrically connected between the circuit node N1 and the voltage VSS. A first terminal of the input capacitor Cin is electrically connected to the circuit node N1. A second terminal of the input capacitor Cin is electrically connected to a radio frequency input node N3.

In the embodiment of the disclosure, the drive transistor Td may be operated as a source follower amplifier. The compensation transistor Tc is configured to let the drive transistor Td to form a diode unit when the compensation transistor Tc is turned on. The bias transistor Tb is configured to provide a first operation voltage (e.g., the operation voltage VDD) to the drive transistor Td when the bias transistor Tb is turned on. In the embodiment of the disclosure, the storage capacitor Cst is configured to hold the voltage for the control terminal of the drive transistor Td. In the embodiment of the disclosure, a control terminal of the compensation transistor Tc and a control terminal of the scan transistor Ts may receive a scan signal SS. A control terminal of the bias transistor Tb may receive a bias signal SB. A radio frequency signal RF-in is transmitted from the radio frequency input node N3 to the circuit node N1.

In the embodiment of the disclosure, the transistors of the electronic device 900 may operate according to the embodiment of FIG. 2. In the embodiment of the disclosure, the input node N3 may receive the radio frequency signal RF-in (AC signal) during the bias period PB, so that the radio frequency signal RF-in may be modulated with the voltage Vdata (DC bias voltage) of the circuit node N1 with capacitive coupling with the input capacitor Cin to generate a modulated signal (DC+AC) to the tunable component 920. In the embodiment of the disclosure, the constant voltage source circuit 910 may effectively and automatically compensate the leakage current of the tunable component 920, and at the same time, the threshold voltage Vth of the driving transistor Td may also be compensated, so that the bias voltage (Vbias) of the tunable component 920 may be effectively maintained.

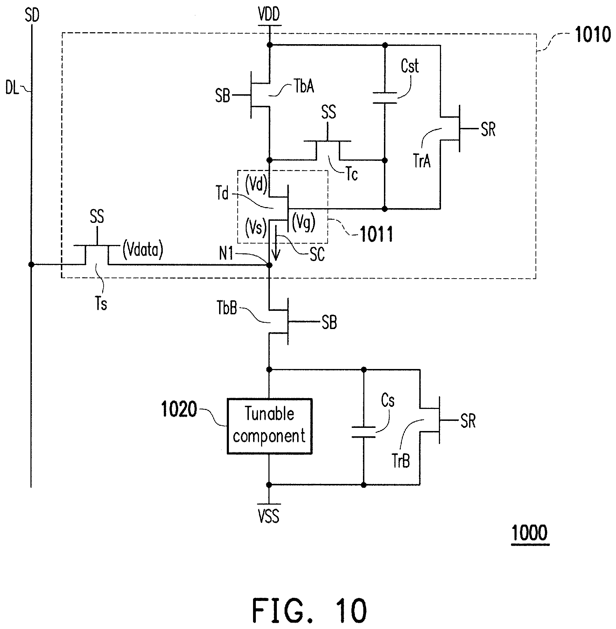

FIG. 10 is a schematic diagram of an electronic device according to an embodiment of the disclosure. Referring to FIG. 10, the electronic device 1000 includes a constant voltage source circuit 1010, a tunable component 1020, a bias transistor TbB, a smoothing capacitor Cs, a reset transistor TrB and a data line DL. The constant voltage source circuit 1010 is electrically connected to the tunable component 1020 and the data line DL. In the embodiment of the disclosure, the constant voltage source circuit 1010 includes a source follower circuit 1011, a compensation transistor Tc, a bias transistor TbA, a scan transistor Ts, a reset transistor TrA and a storage capacitor Cst, and the source follower circuit 1011 includes a drive transistor Td. In the embodiment of the disclosure, the drive transistor Td, the compensation transistor Tc, the bias transistor TbA, the bias transistor TbB, the scan transistor Ts, the reset transistor TrA and the reset transistor TrB are N-type transistors, such as a NMOS. In the embodiment of the disclosure, a first terminal of the drive transistor Td is electrically connected to a first terminal of the compensation transistor Tc. A control terminal of the drive transistor Td is electrically connected to a second terminal of the compensation transistor Tc. A second terminal of the drive transistor Td is electrically connected to a circuit node N1. A first terminal of the bias transistor TbA is electrically connected to an operation voltage VDD. A second terminal of the bias transistor TbA is electrically connected to the first terminal of the drive transistor Td. A first terminal of the storage capacitor Cst is electrically connected to the operation voltage VDD, and a second terminal of the storage capacitor Cst is electrically connected to the second terminal of the compensation transistor Tc and the control terminal of the drive transistor Td. In one embodiment of the disclosure, the second terminal of the storage capacitor Cst may electrically connected to a reference voltage. A first terminal of the scan transistor Ts is electrically connected to the data line DL. A second terminal of the scan transistor Ts is electrically connected to the circuit node N1. A first terminal of the reset transistor TrA is electrically connected to the operation voltage VDD. A second terminal of the reset transistor TrA is electrically connected to the control terminal of the drive transistor Td. A first terminal of the bias transistor TbB is electrically connected to the circuit node N1. The second terminal of the bias transistor TbB is electrically connected to the tunable component 1020. The tunable component 1020 is electrically connected between the second terminal of the bias transistor TbB and the voltage VSS. The smoothing capacitor Cs is electrically connected to the tunable component 1020 in parallel. The reset transistor TrB is electrically connected to the tunable component 1020 in parallel.

In the embodiment of the disclosure, the drive transistor Td may be operated as a source follower amplifier. The compensation transistor Tc is configured to let the drive transistor Td to form a diode unit when the compensation transistor Tc is turned on. The bias transistor TbA and the bias transistor TbB are configured to provide a first operation voltage (e.g., the operation voltage VDD) to the tunable component 1020 through the drive transistor Td when the bias transistor TbA and the bias transistor TbB are turned on. The reset transistor TrA is configured to reset the voltage of the control terminal of the drive transistor Td. The reset transistor TrB is configured to reset the tunable component 1020. In the embodiment of the disclosure, the storage capacitor Cst is configured to hold the voltage for the control terminal of the drive transistor Td. In the embodiment of the disclosure, a control terminal of the compensation transistor Tc and a control terminal of the scan transistor Ts may receive a scan signal SS. A control terminal of the bias transistor TbA and a control terminal of the bias transistor TbB may receive a bias signal SB. A control terminal of the reset transistor TrA and a control terminal of the reset transistor TrB may receive a reset signal SR. The data line DL may transmit a data signal SD.

In the embodiment of the disclosure, the transistors of the electronic device 1000 may operate according to the embodiment of FIG. 4. In the embodiment of the disclosure, the bias transistor TbB may be adapted to cut off the leakage current from the tunable component 1020 during the reset period PR and the scan period PS. The reset transistor TrB may be adapted to reset the bias voltage of the tunable component 1020 during the reset period PR. The smoothing capacitor Cs may be adapted to suppress voltage fluctuation caused by fast leakage current changes and during reset and scan operation.

In the embodiment of the disclosure, the constant voltage source circuit 1010 may effectively and automatically compensate the leakage current of the tunable component 1020, and at the same time, the threshold voltage Vth of the driving transistor Td may also be compensated, so that the bias voltage (Vbias) of the tunable component 1020 may be effectively maintained.

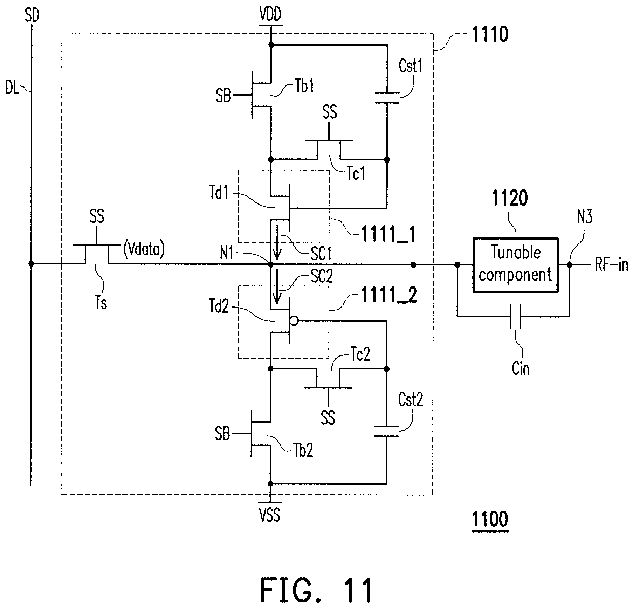

FIG. 11 is a schematic diagram of an electronic device according to an embodiment of the disclosure. Referring to FIG. 11, the electronic device 1100 includes a constant voltage source circuit 1110, a tunable component 1120 and a data line DL. The constant voltage source circuit 1110 is electrically connected to the tunable component 1120 and the data line DL. In the embodiment of the disclosure, the constant voltage source circuit 1110 includes a first source follower circuit 1111_1, a second source follower circuit 1111_2, a first compensation transistor Tc1, a second compensation transistor Tc2, a first bias transistor Tb1, a second bias transistor Tb2, a scan transistor Ts, a first storage capacitor Cst1 and a second storage capacitor Cst2. The first source follower circuit 1111_1 includes a first drive transistor Td1. The second source follower circuit 1111_2 includes a second drive transistor Td2. In the embodiment of the disclosure, the first drive transistor Td1, the first compensation transistor Tc1, the first bias transistor Tb1, the scan transistor Ts, the second compensation transistor Tc2 and the second bias transistor Tb2 are N-type transistors, such as a NMOS. In the embodiment of the disclosure, the second drive transistor Td2 is a P-type transistor, such as a PMOS.

In the embodiment of the disclosure, a first terminal of the first drive transistor Td1 is electrically connected to a first terminal of the first compensation transistor Tc1. A control terminal of the first drive transistor Td is electrically connected to a second terminal of the first compensation transistor Tc1. A second terminal of the first drive transistor Td1 is electrically connected to a circuit node N1. A first terminal of the first bias transistor Tb1 is electrically connected to an operation voltage VDD. A second terminal of the first bias transistor Tb1 is electrically connected to the first terminal of the first drive transistor Td1. A first terminal of the first storage capacitor Cst1 is electrically connected to the operation voltage VDD, and a second terminal of the first storage capacitor Cst1 is electrically connected to the second terminal of the first compensation transistor Tc1 and the control terminal of the first drive transistor Td1. A first terminal of the scan transistor Ts is electrically connected to the data line DL. A second terminal of the scan transistor Ts is electrically connected to the circuit node N1.

In the embodiment of the disclosure, a first terminal of the second drive transistor Td2 is electrically connected to the circuit node N1. A second terminal of the second drive transistor Td2 is electrically connected to a first terminal of the second bias transistor Tb2, and a first terminal of the second compensation transistor Tc2. A control terminal of the second drive transistor Td2 is electrically connected to a second terminal of the second compensation transistor Tc2. A first terminal of the second bias transistor Tb2 is electrically connected to the second terminal of the second drive transistor Td2. A second terminal of the second bias transistor Tb2 is electrically connected to a voltage VSS. A first terminal of the second storage capacitor Cst2 is electrically connected to the control terminal of the second drive transistor Td2 and a second terminal of the second compensation transistor Tc2, and a second terminal of the second storage capacitor Cst2 is electrically connected to the voltage VSS. In the embodiment of the disclosure, the tunable component 1120 is electrically connected between the circuit node N1 and a radio frequency input node N3. An input capacitor Cin is electrically connected to the tunable component 1120 in parallel, or equivalent to parasitic capacitance of the tunable component 1120. In the embodiment of the disclosure, a radio frequency signal RF-in is transmitted from a radio frequency input node N3 to the tunable component 1120.

In the embodiment of the disclosure, the first drive transistor Td1 may be operated as a source follower amplifier. The first compensation transistor Tc1 is configured to let the first drive transistor Td1 to form a diode unit when the first compensation transistor Tc1 is turned on. The first bias transistor Tb1 is configured to provide a first operation voltage (e.g., the operation voltage VDD) to the first drive transistor Td1 when the bias transistor Tb1 is turned on. In the embodiment of the disclosure, the first storage capacitor Cst1 is configured to hold the voltage for the control terminal of the first drive transistor Td1. In the embodiment of the disclosure, the second drive transistor Td2 may be operated as another source follower amplifier. The second compensation transistor Tc2 is configured to let the second drive transistor Td2 to form a diode unit when the second compensation transistor Tc2 is turned on. The second bias transistor Tb2 is configured to provide a second operation voltage (e.g., the voltage VSS) to the second drive transistor Td2 when the second bias transistor Tb2 is turned on. In the embodiment of the disclosure, the second storage capacitor Cst2 is configured to hold the voltage for the control terminal of the second drive transistor Td2. In the embodiment of the disclosure, a control terminal of the first compensation transistor Tc1 and a control terminal of the scan transistor Ts may receive a scan signal SS. A control terminal of the first bias transistor Tb1 may receive a bias signal SB. A control terminal of the second compensation transistor Tc2 may receive a scan signal SS. A control terminal of the second bias transistor Tb2 may receive a bias signal SB. In the embodiment of the disclosure, the data line DL may transmit a data signal SD.

In the embodiment of the disclosure, the operation manner of the electronic device 1100 can be inferred from the description of the above-mentioned embodiments. In the embodiment of the disclosure, the tunable component 1120 may alternately receive the source current SC1 and the sink current SC2 in an oscillating manner, and the input node N3 may receive the radio frequency signal RF-in (AC signal) during the bias period PB, so that the radio frequency signal RF-in may be modulated with the voltage Vdata (DC bias voltage) of the circuit node N1 with capacitive coupling with the input capacitor Cin (AC coupling) to generate a modulated signal (DC+AC) to the tunable component 1120. In the embodiment of the disclosure, the voltage Vdata may higher than the voltage of the radio frequency signal RF-in, and the first drive transistor Td1 may compensate the leakage current of the tunable component 1120 by automatically adjusting the source current SC1 accordingly. The current direction of the leakage current may toward to output to the input node N3. In one embodiment of the disclosure, the voltage of the radio frequency signal RF-in may higher than the voltage Vdata, and the second drive transistor Td2 may compensate the leakage current of the tunable component 1120 by automatically adjusting the source current SC2 accordingly. The current direction of the leakage current may toward to output to the circuit node N1.

In the embodiment of the disclosure, the constant voltage source circuit 1110 may effectively and automatically compensate the leakage current of the tunable component 1120, and at the same time, the threshold voltages Vth of the first driving transistor Td1 and the second driving transistor Td2 may also be compensated, so that the bias voltage (Vbias) of the tunable component 1120 may be effectively maintained.

In addition, in other embodiments of the disclosure, the radio frequency signal RF-in may be replaced by a direct current signal (DC-in). The direct current signal (DC-in) may be transmitted from the input node N3 to the tunable component 1120. Thus, in other embodiments of the disclosure, when the voltage Vdata is higher than the voltage of the direct current signal (DC-in), the first drive transistor Td1 may compensate the leakage current of the tunable component 1120 by automatically adjusting the source current SC1 accordingly. The current direction of the leakage current may toward to output to the input node N3. Moreover, in other embodiments of the disclosure, when the voltage of the direct current signal (DC-in) is higher than the voltage Vdata, the second drive transistor Td2 may compensate the leakage current of the tunable component 1120 by automatically adjusting the source current SC2 accordingly. The current direction of the leakage current may toward to output to the circuit node N1.

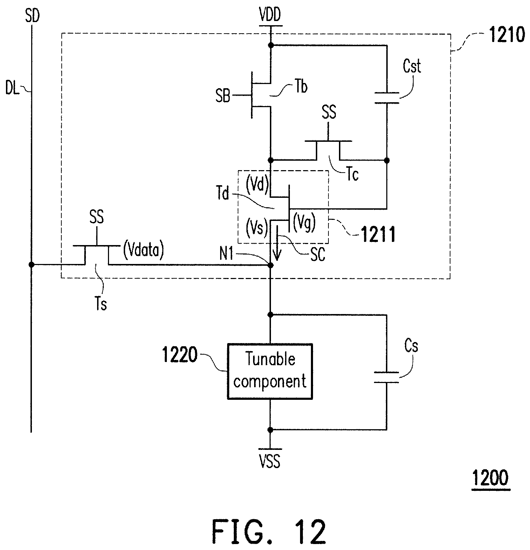

FIG. 12 is a schematic diagram of an electronic device according to an embodiment of the disclosure. Referring to FIG. 12, the electronic device 1200 includes a constant voltage source circuit 1210, a tunable component 1220, smoothing capacitor Cs and a data line DL. The constant voltage source circuit 1210 is electrically connected to the tunable component 1220 and the data line DL. In the embodiment of the disclosure, the constant voltage source circuit 1210 includes a source follower circuit 1211, a compensation transistor Tc, a bias transistor Tb, a scan transistor Ts, a reset transistor Tr and a storage capacitor Cst, and the source follower circuit 1211 includes a drive transistor Td. In the embodiment of the disclosure, the drive transistor Td, the compensation transistor Tc, the bias transistor Tb, the scan transistor Ts and the reset transistor Tr are N-type transistors, such as a NMOS. In the embodiment of the disclosure, a first terminal of the drive transistor Td is electrically connected to a first terminal of the compensation transistor Tc. A control terminal of the drive transistor Td is electrically connected to a second terminal of the compensation transistor Tc. A second terminal of the drive transistor Td is electrically connected to a circuit node N1. A first terminal of the bias transistor Tb is electrically connected to an operation voltage VDD. A second terminal of the bias transistor Tb is electrically connected to the first terminal of the drive transistor Td. A first terminal of the storage capacitor Cst is electrically connected to the operation voltage VDD, and a second terminal of the storage capacitor Cst is electrically connected to the second terminal of the compensation transistor Tc and the control terminal of the drive transistor Td. In one embodiment of the disclosure, the second terminal of the storage capacitor Cst may electrically connected to a reference voltage. A first terminal of the scan transistor Ts is electrically connected to the data line DL. A second terminal of the scan transistor Ts is electrically connected to the circuit node N1. The tunable component 1220 is electrically connected between the circuit node N1 and the ground voltage VSS. The smoothing capacitor Cs is electrically connected to the tunable component 1220 in parallel.

In the embodiment of the disclosure, the drive transistor Td may be operated as a source follower amplifier. The compensation transistor Tc is configured to let the drive transistor Td to form a diode unit when the compensation transistor Tc is turned on. The bias transistor Tb is configured to provide a first operation voltage (e.g., the operation voltage VDD) to the drive transistor Td when the bias transistor Tb is turned on. The storage capacitor Cst is configured to hold the voltage for the control terminal of the drive transistor Td. The reset transistor Tr is configured to reset the voltage of a control terminal of the drive transistor Td. In the embodiment of the disclosure, a control terminal of the compensation transistor Tc and a control terminal of the scan transistor Ts may receive a scan signal SS. A control terminal of the bias transistor Tb may receive a bias signal SB. A control terminal of the reset transistor Tr may receive a reset signal SR. The data line DL may transmit a data signal SD.

In the embodiment of the disclosure, the constant voltage source circuit 1210 may effectively and automatically compensate the leakage current of the tunable component 1220, and at the same time, the threshold voltage Vth of the driving transistor Td may also be compensated, so that the bias voltage (Vbias) of the tunable component 1220 may be effectively maintained.

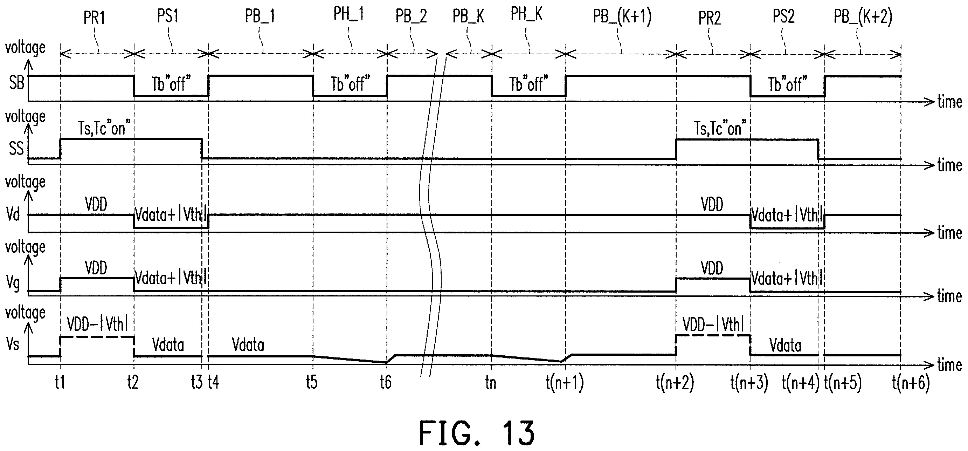

FIG. 13 is a timing diagram of related voltages and signals according to the embodiment of FIG. 12 of the disclosure. In the embodiment of the disclosure, the operation manner of the electronic device 1100 in the reset periods PR1, PR2, the scan periods PS1, PS2 and the bias periods PB_1 to PB_(K+2) can be inferred from the description of the above-mentioned embodiment of the FIG. 2, where K is a positive integer. In the embodiment of the disclosure, a whole frame period, for example from time t1 to time t(n+2), may have multiple bias periods PB_1 to PB_(K+1) and multiple hold periods PH_1 to PH_K that are alternately performed, where n is a positive integer. During the hold periods PH_1 to PH_K, respectively, the bias transistor Tb, the scan transistor Ts and the compensation transistor Tc are turned off by the bias signal SB and the scan signal SS with a low voltage level. In other words, the bias transistor Tb may be turned off periodically to reduce stress of the bias transistor Tb and the drive transistor Td. Moreover, the smoothing capacitor Cs may be adapted to suppress the bias voltage drop during the hold periods PH_1 to PH_K respectively. Besides, the smoothing capacitor Cs may also be applied to each of the constant voltage source circuits of the above-mentioned embodiments.

In summary, the electronic device of the disclosure is capable of effectively compensating the leakage current of the tunable component without requiring the electronic device to operate at a higher refresh rate nor use a larger storage capacitor. Furthermore, in some embodiments of the disclosure, the electronic device also has the advantage that the stress of the transistor can be effectively relieved.

## Claims

1. An electronic device (100, 300, 500, 700, 900, 1000, 1100, 1200), comprising:
a tunable component (120, 320, 520, 720, 920, 1020, 1120, 1220), electrically connected to a circuit node (N1, N2); and
a first source follower circuit (111, 311, 511, 711, 911, 1011, 1111_1, 1211), electrically connected to the circuit node (N1, N2), and comprising a first control terminal and a first terminal;
the electronic device further comprising:
a first compensation transistor (Tc, Tc1);
a first storage capacitor (Cst, Cst1), wherein a first terminal of the first storage capacitor (Cst, Cst1) is electrically connected to a first operation voltage, and a second terminal of the first storage capacitor (Cst, Cst1) is electrically connected to the first control terminal of the first source follower circuit (111, 311, 511, 711, 911, 1011, 1111_1, 1211) and the first compensation transistor (Tc, Tc1), wherein a first terminal of the first compensation transistor (Tc, Tc1) is electrically connected to the first terminal of the first source follower circuit (111, 311, 511, 711, 911, 1011, 1111_1, 1211), and a second terminal of the first compensation transistor (Tc, Tc1) is electrically connected to the first control terminal of the first source follower circuit (111, 311, 511, 711, 911, 1011, 1111_1, 1211) and the second terminal of the first storage capacitor (Cst, Cst1); and
a first bias transistor (Tb, Tb1, TbA),
wherein a first terminal of the first bias transistor (Tb, Tb1, TbA) is electrically connected to the first operation voltage, and a second terminal of the first bias transistor (Tb, Tb1, TbA) is electrically connected to the first terminal of the first source follower circuit (111, 311, 511, 711, 911, 1011, 1111_1, 1211).

2. The electronic device (100, 300, 500, 700, 900, 1000, 1100, 1200) according to the claim 1, further comprising:
a first reset transistor (Tr, TrA), electrically connected to the first control terminal of the first source follower circuit (111, 311, 511, 711, 911, 1011, 1111_1, 1211).

3. The electronic device (100, 300, 500, 700, 900, 1000, 1100, 1200) according to the claim 1, wherein a current is transmitted from the first source follower circuit (111, 311, 511, 711, 911, 1011, 1111_1, 1211) to the tunable component (120, 320, 520, 720, 920, 1020, 1120, 1220).

4. The electronic device (100, 300, 500, 700, 900, 1000, 1100, 1200) according to the claim 1, wherein a current is transmitted from the tunable component (120, 320, 520, 720, 920, 1020, 1120, 1220) to the first source follower circuit (111, 311, 511, 711, 911, 1011, 1111_1, 1211).

5. The electronic device according to the claim 1, wherein the first source follower circuit (111, 311, 511, 711, 911, 1011, 1111_1, 1211) comprises a first drive transistor (Td, Td1).

6. The electronic device (100, 300, 500, 700, 900, 1000, 1100, 1200) according to the claim 1, further comprising:
a smoothing capacitor (Cs), electrically connected to the tunable component (120, 320, 520, 720, 920, 1020, 1120, 1220) in parallel.

7. The electronic device (100, 300, 500, 700, 900, 1000, 1100, 1200) according to the claim 1, further comprising:
a second source follower circuit (1111_2), electrically connected to the circuit node (N1),
wherein the second source follower circuit (1111_2) comprises a second control terminal and a second terminal, and the second control terminal is electrically connected to the second terminal.

8. The electronic device (100, 300, 500, 700, 900, 1000, 1100, 1200) according to the claim 7, wherein the second source follower circuit (1111_2) comprises a second drive transistor (Td2), wherein the second drive transistor is a N-type transistor or a P-type transistor.

9. The electronic device (100, 300, 500, 700, 900, 1000, 1100, 1200) according to the claim 7, further comprising:
a second compensation transistor (Tc2), electrically connected to the second control terminal and the second terminal of the second source follower circuit (1111_2).

10. The electronic device (100, 300, 500, 700, 900, 1000, 1100, 1200) according to the claim 7, further comprising:
a second bias transistor (Tb2), electrically connected to the second terminal of the second source follower circuit (1111_2) and a second operation voltage;
a second storage capacitor (Cst2), electrically connected to the second control terminal of the second source follower circuit (1111_2); and
a second reset transistor (Tr2), electrically connected to the second control terminal of the second source follower circuit (1111_2).

11. The electronic device (100, 300, 500, 700, 900, 1000, 1100, 1200) according to the claim 1, further comprising:
a scan transistor (Ts), electrically connected to the circuit node (N1, N2), wherein the scan transistor (Ts) is further electrically connected to a data line (DL).

12. The electronic device (100, 300, 500, 700, 900, 1000, 1100, 1200) according to the claim 1, further comprising:
a third reset transistor (TrB), electrically connected to the tunable component (120, 320, 520, 720, 920, 1020, 1120, 1220) in parallel; and
a third bias transistor (TbB), electrically connected between the circuit node (N1, N2) and the tunable component (120, 320, 520, 720, 920, 1020, 1120, 1220).

## Patentansprüche

1. Elektronische Vorrichtung (100, 300, 500, 700, 900, 1000, 1100, 1200), umfassend:
eine abstimmbare Komponente (120, 320, 520, 720, 920, 1020, 1120, 1220), die elektrisch mit einem Schaltungsknoten (N1, N2) verbunden ist; und
eine erste Source-Follower-Schaltung (111, 311, 511, 711, 911, 1011, 1111_1, 1211), die elektrisch mit dem Schaltungsknoten (N1, N2) verbunden ist und einen ersten Steueranschluss sowie einen ersten Anschluss umfasst; wobei die elektronische Vorrichtung ferner umfasst:
einen ersten Kompensationstransistor (Tc, Tc1);
einen ersten Speicherkondensator (Cst, Cst1), wobei ein erster Anschluss des ersten Speicherkondensators (Cst, Cst1) elektrisch mit einer ersten Betriebsspannung verbunden ist und ein zweiter Anschluss des ersten Speicherkondensators (Cst, Cst1) elektrisch mit dem ersten Steueranschluss der ersten Source-Follower-Schaltung (111, 311, 511, 711, 911, 1011, 1111_1, 1211) und dem ersten Kompensationstransistor (Tc, Tc1) verbunden ist, wobei ein erster Anschluss des ersten Kompensationstransistors (Tc, Tc1) elektrisch mit dem ersten Anschluss der ersten Source-Follower-Schaltung (111, 311, 511, 711, 911, 1011, 1111_1, 1211) verbunden ist und ein zweiter Anschluss des ersten Kompensationstransistors (Tc, Tc1) elektrisch mit dem ersten Steueranschluss der ersten Source-Follower-Schaltung (111, 311, 511, 711, 911, 1011, 1111_1, 1211) und dem zweiten Anschluss des ersten Speicherkondensators (Cst, Cst1) elektrisch verbunden ist; und
einen ersten Bias-Transistor (Tb, Tb1, TbA),
wobei ein erster Anschluss des ersten Bias-Transistors (Tb, Tb1, TbA) elektrisch mit der ersten Betriebsspannung verbunden ist und ein zweiter Anschluss des ersten Bias-Transistors (Tb, Tb1, TbA) elektrisch mit dem ersten Anschluss der ersten Source-Follower-Schaltung (111, 311, 511, 711, 911, 1011, 1111_1, 1211) verbunden ist.

2. Elektronische Vorrichtung (100, 300, 500, 700, 900, 1000, 1100, 1200) nach Anspruch 1, ferner umfassend:
einen ersten Reset-Transistor (Tr, TrA), der elektrisch mit dem ersten Steueranschluss der ersten Source-Follower-Schaltung (111, 311, 511, 711, 911, 1011, 1111_1, 1211) verbunden ist.

3. Elektronische Vorrichtung (100, 300, 500, 700, 900, 1000, 1100, 1200) nach Anspruch 1, wobei ein Strom von der ersten Source-Follower-Schaltung (111, 311, 511, 711, 911, 1011, 1111_1, 1211) zu der abstimmbaren Komponente (120, 320, 520, 720, 920, 1020, 1120, 1220) übertragen wird.

4. Elektronische Vorrichtung (100, 300, 500, 700, 900, 1000, 1100, 1200) nach Anspruch 1, wobei ein Strom von der abstimmbaren Komponente (120, 320, 520, 720, 920, 1020, 1120, 1220) zu der ersten Source-Follower-Schaltung (111, 311, 511, 711, 911, 1011, 1111_1, 1211) übertragen wird.

5. Elektronische Vorrichtung nach Anspruch 1, wobei die erste Source-Follower-Schaltung (111, 311, 511, 711, 911, 1011, 1111_1, 1211) einen ersten Treibertransistor (Td, Td1) umfasst.

6. Elektronische Vorrichtung (100, 300, 500, 700, 900, 1000, 1100, 1200) nach Anspruch 1, ferner umfassend:
einen Glättungskondensator (Cs), der parallel zu der abstimmbaren Komponente (120, 320, 520, 720, 920, 1020, 1120, 1220) elektrisch verbunden ist.

7. Elektronische Vorrichtung (100, 300, 500, 700, 900, 1000, 1100, 1200) nach Anspruch 1, ferner umfassend:
eine zweite Source-Follower-Schaltung (1111_2), die elektrisch mit dem Schaltungsknoten (N1) verbunden ist,
wobei die zweite Source-Follower-Schaltung (1111_2) einen zweiten Steueranschluss und einen zweiten Anschluss umfasst und der zweite Steueranschluss elektrisch mit dem zweiten Anschluss verbunden ist.

8. Elektronische Vorrichtung (100, 300, 500, 700, 900, 1000, 1100, 1200) nach Anspruch 7, wobei die zweite Source-Follower-Schaltung (1111_2) einen zweiten Treibertransistor (Td2) umfasst, wobei der zweite Treibertransistor ein N-Typ-Transistor oder ein P-Typ-Transistor ist.

9. Elektronische Vorrichtung (100, 300, 500, 700, 900, 1000, 1100, 1200) nach Anspruch 7, ferner umfassend:
einen zweiten Kompensationstransistor (Tc2), der elektrisch mit dem zweiten Steueranschluss und dem zweiten Anschluss der zweiten Source-Follower-Schaltung (1111_2) verbunden ist.

10. Elektronische Vorrichtung (100, 300, 500, 700, 900, 1000, 1100, 1200) nach Anspruch 7, ferner umfassend:
einen zweiten Bias-Transistor (Tb2), der elektrisch mit dem zweiten Anschluss der zweiten Source-Follower-Schaltung (1111_2) und einer zweiten Betriebsspannung verbunden ist;
einen zweiten Speicherkondensator (Cst2), der elektrisch mit dem zweiten Steueranschluss der zweiten Source-Follower-Schaltung (1111_2) verbunden ist; und
einen zweiten Reset-Transistor (Tr2), der elektrisch mit dem zweiten Steueranschluss der zweiten Source-Follower-Schaltung (1111_2) verbunden ist.

11. Elektronische Vorrichtung (100, 300, 500, 700, 900, 1000, 1100, 1200) nach Anspruch 1, ferner umfassend:
einen Scan-Transistor (Ts), der elektrisch mit dem Schaltungsknoten (N1, N2) verbunden ist, wobei der Scan-Transistor (Ts) ferner elektrisch mit einer Datenleitung (DL) verbunden ist.

12. Elektronische Vorrichtung (100, 300, 500, 700, 900, 1000, 1100, 1200) nach Anspruch 1, ferner umfassend:
einen dritten Reset-Transistor (TrB), der parallel zu der abstimmbaren Komponente (120, 320, 520, 720, 920, 1020, 1120, 1220) elektrisch verbunden ist; und
einen dritten Bias-Transistor (TbB), der elektrisch zwischen dem Schaltungsknoten (N1, N2) und der abstimmbaren Komponente (120, 320, 520, 720, 920, 1020, 1120, 1220) verbunden ist.

## Revendications

1. Dispositif électronique (100, 300, 500, 700, 900, 1000, 1100, 1200), comprenant :
un composant accordable (120, 320, 520, 720, 920, 1020, 1120, 1220), connecté électriquement à un noeud de circuit (N1, N2) ; et
un premier circuit suiveur de source (111, 311, 511, 711, 911, 1011, 1111_1, 1211), connecté électriquement au noeud de circuit (N1, N2), et comprenant une première borne de commande et une première borne ;
un premier transistor de compensation (Tc, Tc1) ;
un premier condensateur de stockage (Cst, Cst1), dans lequel une première borne du premier condensateur de stockage (Cst, Cst1) est connectée électriquement à une première tension de fonctionnement, et une deuxième borne du premier condensateur de stockage (Cst, Cst1) est connectée électriquement à la première borne de commande du premier circuit suiveur de source (111, 311, 511, 711, 911, 1011, 1111_1, 1211) et au premier transistor de compensation (Tc, Tc1), dans lequel une première borne du premier transistor de compensation (Tc, Tc1) est connectée électriquement à la première borne du premier circuit suiveur de source (111, 311, 511, 711, 911, 1011, 1111_1, 1211), et une deuxième borne du premier transistor de compensation (Tc, Tc1) est connectée électriquement à la première borne de commande du premier circuit suiveur de source (111, 311, 511, 711, 911, 1011, 1111_1, 1211) et à la deuxième borne du premier condensateur de stockage (Cst, Cst1) ; et
un premier transistor de polarisation (Tb, Tb1, TbA), dans lequel une première borne du premier transistor de polarisation (Tb, Tb1, TbA) est connectée électriquement à la première tension de fonctionnement, et une deuxième borne du premier transistor de polarisation (Tb, Tb1, TbA) est connectée électriquement à la première borne du premier circuit suiveur de source (111, 311, 511, 711, 911, 1011, 1111_1, 1211).

2. Dispositif électronique (100, 300, 500, 700, 900, 1000, 1100, 1200) selon la revendication 1, comprenant en outre :un premier transistor de réinitialisation (Tr, TrA), connecté électriquement à la première borne de commande du premier circuit suiveur de source (111, 311, 511, 711, 911, 1011, 1111_1, 1211).

3. Dispositif électronique (100, 300, 500, 700, 900, 1000, 1100, 1200) selon la revendication 1, dans lequel un courant est transmis depuis le premier circuit suiveur de source (111, 311, 511, 711, 911, 1011, 1111_1, 1211) vers le composant accordable (120, 320, 520, 720, 920, 1020, 1120, 1220).

4. Dispositif électronique (100, 300, 500, 700, 900, 1000, 1100, 1200) selon la revendication 1, dans lequel un courant est transmis depuis le composant accordable (120, 320, 520, 720, 920, 1020, 1120, 1220) vers le premier circuit suiveur de source (111, 311, 511, 711, 911, 1011, 1111_1, 1211).

5. Dispositif électronique selon la revendication 1, dans lequel le premier circuit suiveur de source (111, 311, 511, 711, 911, 1011, 1111_1, 1211) comprend un premier transistor de commande (Td, Td1).

6. Dispositif électronique (100, 300, 500, 700, 900, 1000, 1100, 1200) selon la revendication 1, comprenant en outre :
un condensateur de lissage (Cs), connecté électriquement au composant accordable (120, 320, 520, 720, 920, 1020, 1120, 1220) en parallèle.

7. Dispositif électronique (100, 300, 500, 700, 900, 1000, 1100, 1200) selon la revendication 1, comprenant en outre :
un deuxième circuit suiveur de source (1111_2), connecté électriquement au noeud de circuit (N1),dans lequel le deuxième circuit suiveur de source (1111_2) comprend une deuxième borne de commande et une deuxième borne, et la deuxième borne de commande est connectée électriquement à la deuxième borne.

8. Dispositif électronique (100, 300, 500, 700, 900, 1000, 1100, 1200) selon la revendication 7, dans lequel le deuxième circuit suiveur de source (1111_2) comprend un deuxième transistor de commande (Td2), dans lequel le deuxième transistor d'attaque est un transistor de type N ou un transistor de type P.

9. Dispositif électronique (100, 300, 500, 700, 900, 1000, 1100, 1200) selon la revendication 7, comprenant en outre :
un deuxième transistor de compensation (Tc2), connecté électriquement à la deuxième borne de commande et à la deuxième borne du deuxième circuit suiveur de source (1111_2).

10. Dispositif électronique (100, 300, 500, 700, 900, 1000, 1100, 1200) selon la revendication 7, comprenant en outre :un deuxième transistor de polarisation (Tb2), connecté électriquement à la deuxième borne du deuxième circuit suiveur de source (1111_2) et à une deuxième tension de fonctionnement ;un deuxième condensateur de stockage (Cst2), connecté électriquement à la deuxième borne de commande du deuxième circuit suiveur de source (1111_2) ; et
un deuxième transistor de réinitialisation (Tr2), connecté électriquement à la deuxième borne de commande du deuxième circuit suiveur de source (1111_2).

11. Dispositif électronique (100, 300, 500, 700, 900, 1000, 1100, 1200) selon la revendication 1, comprenant en outre :un transistor de balayage (Ts), connecté électriquement au noeud de circuit (N1, N2), dans lequel le transistor de balayage (Ts) est en outre connecté électriquement à une ligne de données (DL).

12. Dispositif électronique (100, 300, 500, 700, 900, 1000, 1100, 1200) selon la revendication 1, comprenant en outre :un troisième transistor de réinitialisation (TrB), connecté électriquement au composant accordable (120, 320, 520, 720, 920, 1020, 1120, 1220) en parallèle ; et
un troisième transistor de polarisation (TbB), connecté électriquement entre le noeud de circuit (N1, N2) et le composant accordable (120, 320, 520, 720, 920, 1020, 1120, 1220).
